# EUROPEAN PATENT APPLICATION

(11) **EP 4 821 751 A1**
(43) Date of publication of application: **14.10.2026**
(21) Application number: 24900985.3
(22) Date of filing: 29.11.2024
(51) Int. Cl.: B60L 53/60, B60L 53/30, G01R 31/36, G01R 19/165

(54) **ELECTRIC VEHICLE CHARGING CONTROLLER AND CHARGING CONTROL METHOD THEREOF**

(30) Priority: 05.12.2023 KR 20230174618
(71) Applicant: LG Innotek Co., Ltd., Seoul 07796 (KR)
(72) Inventor: SHIN, Kwang Seob, Seoul 07796 (KR); KIM, Hyun Woong, Seoul 07796 (KR); SONG, Il Jong, Seoul 07796 (KR)
(74) Representative: Plasseraud IP
(86) International application number: PCT/KR2024/019339
(87) International publication number: WO 2025/121799

(57) **Abstract**

An electric vehicle charging controller (EVCC) according to an embodiment of the present invention comprises: a charge sequence signal 1 (CSS1) detection unit for sensing a first charging sequence signal received from electric vehicle supply equipment (EVSE) via a CSS1 line; a CSS2 detection unit for sensing a second charging sequence signal received from the EVSE via a CSS2 line; a negative voltage detection unit for detecting a negative voltage of a connector proximity detection line; and a control unit for determining that a protective earth (PE) between the EVSE and the electric vehicle charging controller is opened when a voltage value detected by the negative voltage detection unit is within a prescribed value.

## Description

### [Technical Field]

The present invention relates to an electric vehicle (EV), and more specifically, to an EV charging controller and a charging control method thereof.

### [Background Art]

Eco-friendly vehicles such as electric vehicles (EVs) or plug-in hybrid electric vehicles (PHEVs) use electric vehicle supply equipment (EVSE) installed at charging stations to charge their batteries.

In order for charging of the EV, the EV and EVSE communicate using a charging connector connected between the EVSE and the EV. When the charging connector is connected between the EVSE and the EV, charging begins after signaling for the charging is performed between the EVSE and the EV.

Meanwhile, a high-voltage current flows between the EVSE and the EV, and, when an emergency shutdown is required, a stopping message corresponding to a reason for the shutdown may be transmitted from the EV to the EVSE.

When a protective earth (PE) line, which is a grounding wire between the EVSE and the EV, is opened, an emergency shutdown is required for a safety reason. Accordingly, a technique for detecting a PE open quickly and accurately is required.

### [Description of Invention]

### [Technical Problem]

The technical problem to be solved by the present invention is to provide an electric vehicle (EV) charging controller for quickly and accurately detecting whether a protective earth (PE) is open and a charging control method thereof.

### [Technical Solution]

An electric vehicle (EV) charging controller (EVCC) according to one embodiment of the present invention includes a charge sequence signal 1 (CSS1) detector configured to detect a first charge sequence signal received from electric vehicle supply equipment (EVSE) through a CSS1 line, a charge sequence signal 2 (CSS2) detector configured to detect a second charge sequence signal received from the EVSE through a CSS2 line, a negative voltage detector configured to detect a negative voltage of a connector proximity detection line, and a controller configured to determine that a protective earth PE between the EVSE and the EVCC is opened when a voltage value detected by the negative voltage detector is within a predetermined value.

The controller may estimate a negative voltage of the voltage value detected by the negative voltage detector using a pre-stored voltage matching table.

The negative voltage detector may include a back-to-back field effect transistor (FET) and a negative voltage monitoring circuit that are connected to the connector proximity detection line, and the negative voltage monitoring circuit may include a voltage divider resistor and an operational amplifier (OP Amp).

The voltage divider resistor may include a first resistor and a second resistor, one end of the first resistor may be connected to the connector proximity detection line, and the other end of the first resistor may be connected to one end of the second resistor and the OP Amp.

The first resistor may have a resistance of 100 kΩ or more.

The EVCC may further include a proximity signal detector connected to the connector proximity detection line and configured to detect a connector proximity signal of the EVSE, and the proximity signal detector may include a voltage divider resistor and an OP Amp.

The CSS1 detector may include a voltage divider resistor and an OP Amp, and the controller may determine whether the first charge sequence signal is received according to a voltage value detected by the CCS1 detector.

The voltage divider resistor may include a first resistor and a second resistor, one end of the first resistor may be connected to the CSS1 line, the other end of the first resistor may be connected to one end of the second resistor and the OP Amp, and the first resistor may have a resistance of 100 kΩ or more.

The CCS2 detector may include a voltage divider resistor and an OP Amp, and the controller may determine whether the second charge sequence signal is received according to a voltage value detected by the CCS2 detector.

The voltage divider resistor may include a first resistor and a second resistor, one end of the first resistor may be connected to the CSS2 line, the other end of the first resistor may be connected to one end of the second resistor and the OP Amp, and the first resistor may have a resistance of 100 kΩ or more.

A charging control method of an EVCC according to one embodiment of the present invention includes detecting a first charge sequence signal received from electric vehicle supply equipment (EVSE) through a charge sequence signal 1 (CSS1) line, detecting a second charge sequence signal received from the EVSE through a charge sequence signal 2 (CSS2) line, detecting a voltage of a connector proximity detection line, and determining that a protective earth (PE) between the EVSE and the EVCC is opened when a voltage value detected at the connector proximity detection line is within a predetermined value.

The determining that the PE is opened may include estimating a negative voltage of the voltage value detected at the connector proximity detection line using a pre-stored voltage matching table.

### [Advantageous Effects]

According to embodiments of the present invention, an electric vehicle (EV) charging controller (EVCC) that quickly and accurately detects whether a protective earth (PE) between electric vehicle supply equipment (EVSE) and an EV is open can be provided. According to embodiments of the present invention, expensive components are replaced with inexpensive components so that costs can be reduced, and whether a PE between EVSE and an EV is open can be detected quickly and accurately.

### [Description of Drawings]

FIGS. 1 to 3 are diagrams illustrating a charging system for an electric vehicle (EV) according to one embodiment of the present invention.
FIG. 4 is a diagram illustrating an example of a pinout of a connector included in an EV charging controller (EVCC) according to an embodiment of the present invention.
FIG. 5 is a diagram illustrating an example of a charging interface between EV supply equipment (EVSE) and the EV.
FIGS. 6 and 7 are equivalent circuit diagrams of the charging interface between the EVSE and the EVCC according to an embodiment of the present invention.

### [Modes of the Invention]

Hereinafter, exemplary embodiments of the present invention will be described in detail with reference to the accompanying drawings.

However, the technical idea of the present invention is not limited to some embodiments to be described but may be implemented in various different forms, and, within the scope of the technical idea of the present invention, one or more among components in the embodiments may be used by being selectively combined and substituted.

Further, unless specifically defined and described, terms used in the embodiments of the present invention (including technical and scientific terms) may be construed as meanings which are generally understood by those skilled in the art to which the present invention pertains, and generally used terms such as terms defined in the dictionary may be interpreted in consideration of the contextual meaning of the related art.

In addition, terms used in the embodiments of the present invention are intended to describe the embodiments and are not intended to limit the present invention.

In the present specification, the singular forms may include the plural forms unless the context clearly dictates otherwise, and when described as "at least one (or one or more) among A, B, and (or) C," it may include one or more of all possible combinations of A, B, and C.

In addition, in describing components of embodiments of the present invention, the terms first, second, A, B, (a), (b), and the like can be used.

These terms are intended to distinguish one component from other components, but the nature and the order or sequence of the components is not limited by those terms.

Further, when a component is described as being "linked," "coupled," or "connected" to another component, the component is not only directly linked, coupled, or connected to the other component, but also "linked," "coupled," or "connected" to another component due to still another component between the component and another component.

Further, when a component is described as being formed or disposed "on (above) or under (below)" of another component, the term "on (above) or under (below)" includes not only when two components are in direct contact with each other, but also when one or more of other components are formed or disposed between the two components. Further, when a component is described as being "on (above) or below (under)," the description may include the meanings of an upward direction and a downward direction based on one component.

Hereinafter, embodiments of the present invention will be described in detail with reference to the drawings, the same reference numerals are given to the same or corresponding components regardless of a number of the drawing, and duplicate descriptions thereof will be omitted herein.

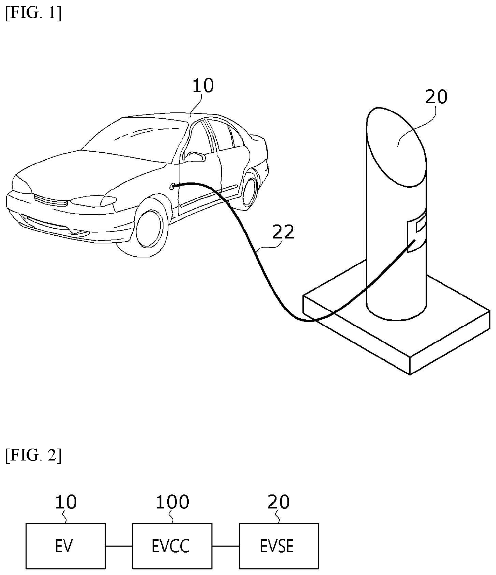

FIGS. 1 to 3 are diagrams illustrating a charging system for an electric vehicle (EV) according to one embodiment of the present invention.

Referring to FIGS. 1 to 3, an EV 10 may be charged by EV supply equipment (EVSE) 20. To this end, a charging cable 22 connected to the EVSE 20 may be connected to an inlet of the EV 10. Here, the EVSE 20 is equipment that supplies AC or DC power, may be disposed at a charging station or home, and may be implemented to be portable. The EVSE 20 may be used interchangeably with a supply, an AC supply, a DC supply, a socket-outlet, etc.

An EV charging controller (EVCC) 100 is installed in the EV 10 and connected to the EV 10. For example, the EVCC 100 may be installed in a trunk of the EV 10, but the present invention is not limited thereto.

Here, the EVCC 100 may communicate with the EV 10 and the EVSE 20.

According to an embodiment of the present invention, the EVCC 100 includes a controller 110, a connector 120, and a detector 130.

The controller 110 generates a control signal for charging between the EV 10 and the EVSE 20. The control signal for charging generated by the controller 110 may be transmitted to the EVSE 20 through the connector 120 or to an electronic control unit (ECU) 12 in the EV 10.

The connector 120 is connected to the EVSE 20 and transmits signals between the controller 110 and the EVSE 20. For example, the connector 120 may transmit a charging-related signal received from the EVSE 20 to the controller 110 and transmit the control signal for charging generated by the controller 110 to the EVSE 20. In addition, the connector 120 transmits power, which is received from the EVSE 20, to a battery 14 in the EV 10 according to the control signal for charging generated by the controller 110.

The detector 130 detects a charging-related signal between the EV 10 and the EVSE 20. The detector 130 is connected to the connector 120 and the controller 110 and may transmit a value, which is detected at the connector 120, to the controller 110.

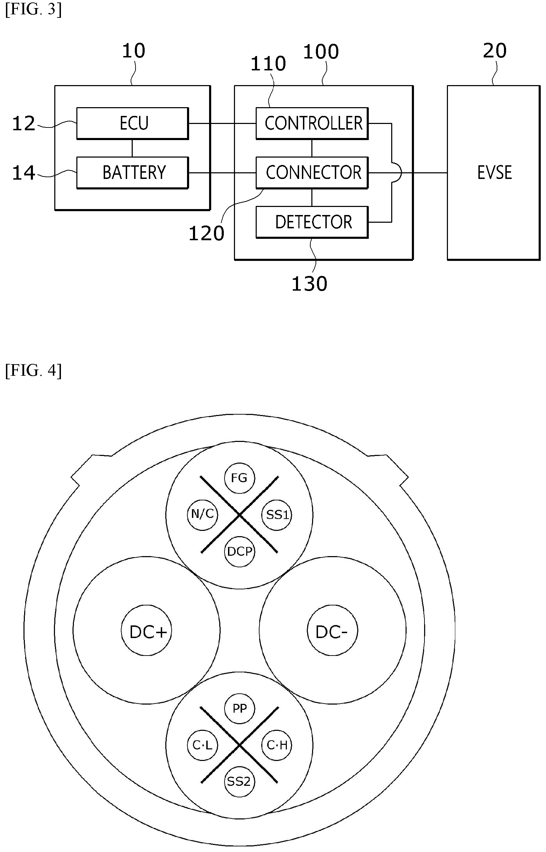

FIG. 4 is a diagram illustrating an example of a pinout of the connector included in the EVCC according to an embodiment of the present invention. The pinout exemplified in FIG. 4 may have a shape that is shown at an end portion of the connector at an EV.

Referring to FIG. 4, the connector 120 may include a total of 10 pins. For example, the connector 120 may include an FG pin, an SS1 pin, an SS2 pin, an N/C pin, a DCP pin, a DC+ pin, a DC- pin, a PP pin, a C-H pin, and a C-L pin.

Here, the FG pin is a ground pin and may be a reference with respect to a control line. The FG pin may be included in a grounding wire between the EVSE 20 and the EVCC 100, i.e., a protective earth (PE). Each of the SS1 pin and the SS2 pin is a pin that receives a charge sequence signal from the EVSE 20 and may provide a load current to a relay at an EV 10. The SS1 pin and the SS2 pin may be referred to as a charge start and stop 1 pin and a charge start and stop 2 pin, respectively, or as a charge sequence signal 1 pin and a charge sequence signal 2 pin.

The N/C pin may be a not-connected pin.

The DCP pin is a pin that transmits a charge permission signal to the EVSE 20 and may be referred to as a charge permission and prohibition pin or a vehicle charge permission pin.

The DC-pin and the DC+ pin may be rapid terminals that receive power from the EVSE 20.

The PP pin is a pin that receives a connector proximity detection signal of the EVSE 20 and may be referred to as a verification of connector connection pin or a connector proximity detection pin. The PP pin may be a pin for determining a connection of the charging cable.

The C-H pin and the C-L pin may be controller area network (CAN) buses that communicate with an EV bus in order to set operation parameters. When the PP pin determines the connection of the charging cable, information on the battery of the EV 10 is transmitted to the EVSE 20 through the C-H pin and the C-L pin, information of the EVSE 20 is transmitted to the EV 10, and a compatibility test between the EV 10 and the EVSE 20 may be performed.

Meanwhile, an end portion of the connector at an EVSE 20 may also have a shape corresponding to the end portion of the connector at the EV 10.

That is, the end portion of the connector in the EVSE 20 may include a pin that transmits a first charge sequence signal to the EV 10 and corresponds to the SS1 pin of FIG. 4, a pin that transmits a second charge sequence signal to the EV 10 and corresponds to the SS2 pin of FIG. 4, a pin that transmits a connector proximity detection signal to the EV 10 and corresponds to the PP pin of FIG. 4, a pin that receives a charge permission signal from the EV 10 and corresponds to the DCP pin of FIG. 4, and rapid terminals that transmit power to the EV 10 and correspond to the DC- pin and the DC+ pin of FIG. 4.

In addition, the end portion of the connector at the EVSE 20 may further include a pin corresponding to at least one of the FG pin, the N/C pin, the C-H pin, and the C-L pin of FIG. 4.

As described above, the EVCC 100 may be installed in the EV 10. Therefore, the EV 10 in the present specification may refer to the EVCC 100.

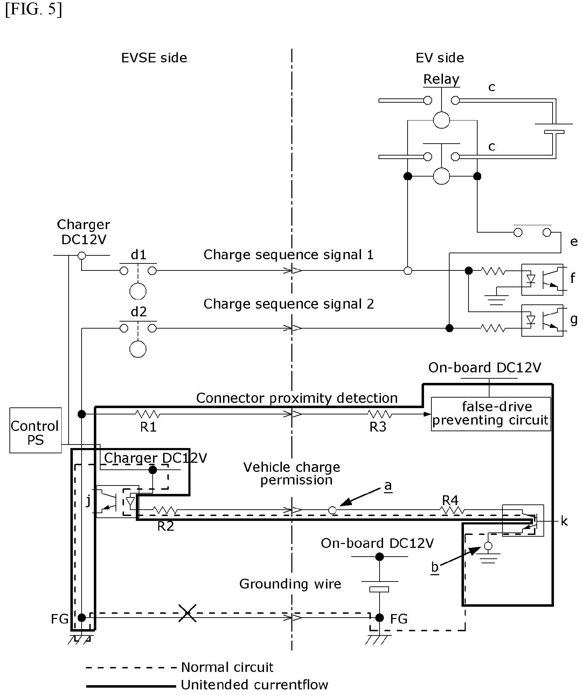

FIG. 5 is a diagram illustrating an example of a charging interface between the EVSE and the EV. The charging interface between the EVSE and the EV may be a circuit in a state in which the end portion of the connector in the EV 10 and the end portion of the connector in the EVSE 20 are connected.

Referring to FIG. 5, when a switch d1 is pressed at the EVSE 20, the first charge sequence signal is transmitted from the EVSE 20 to the EV 10 through an SS1 line, i.e., a charge sequence signal 1 CSS 1 line, and thus a current flows in an optocoupler f at the EV.

In addition, when a switch d2 is pressed at the EVSE 20, a second charge sequence signal is transmitted from the EVSE 20 to the EV 10 through an SS2 line, that is, a charge sequence signal 2 CSS 2 line, and thus a current flows in the optocoupler g at the EV 10.

And, when the connector proximity detection signal of the EVSE 20 is transmitted from the EVSE 20 to the EV 10 through a PP line, that is, a connector proximity detection line, the EV 10 may detect whether the connector is properly connected.

Thereafter, when charging is prepared at the EV 10 and a transistor k is pressed, a ground is activated, a current path is formed, and a charge permission signal is transmitted to the EVSE 20 through a DCP line, i.e., a vehicle charge permission line, and thus a current flows in an optocoupler j at the EVSE 20.

When the transmission of the first charge sequence signal from the EVSE 20 to the EV 10, the transmission of the second charge sequence signal from the EVSE 20 to the EV 10, the transmission of the connector proximity detection signal from the EVSE 20 to the EV 10, and the transmission of the charge permission signal from the EV 10 to the EVSE 20 are completed, the battery relay at the EV 10 is turned on and charging may begin.

The order of the transmission of the first charge sequence signal from the EVSE 20 to the EV 10, the transmission of the second charge sequence signal from the EVSE 20 to the EV 10, the transmission of the connector proximity detection signal from the EVSE 20 to the EV 10, and the transmission of the charge permission signal from the EV 10 to the EVSE 20 is not limited thereto. For example, the order of the transmission of the first charge sequence signal from the EVSE 20 to the EV 10, the transmission of the connector proximity detection signal from the EVSE 20 to the EV 10, the transmission of the charge permission signal from the EV 10 to the EVSE 20, and the transmission of the second charge sequence signal from the EVSE 20 to the EV 10 may be performed.

The requirements for each component at the EVSE side in the circuit diagram shown in FIG. 5 are as shown in Table 1.

**[Table 1]**

| Terminal | Item | Minimum value | Typical value | Maximum value | Unit |
|---|---|---|---|---|---|
| Charge sequence signal 1 | Charger DC12V | 10.8 | 12.0 | 13.2 | V |
| Connector proximity detection | Resistor R1 | 190 | 200 | 210 | Ω |
| Vehicle charge permission | Resistor R2 | 950 | 1000 | 1050 | Ω |
| Charge sequence signal 1 | Relay d1 load current | 2 | | 2000 | mA |
| Charge sequence signal 2 | Relay d2 load current | 2 | | 2000 | mA |

The requirements for each component at the EV in the circuit diagram shown in FIG. 5 are as shown in Table 2.

**[Table 2]**

| Terminal | Item | Minimum value | Typical value | Maximum value | Unit |
|---|---|---|---|---|---|
| Charge sequence signal 1 | Load current (when d1 ON) | 10 | | 2000 | mA |
| Charge sequence signal 2 | Load current (when d1 an d2 ON) | 10 | | 2000 | mA |
| Connector proximity detection | Resistor R3 | 950 | 1000 | 1050 | Ω |
| | On-board DC 12V | 8 | 12 | 16 | V |
| Vehicle charge permission | Resistor R4 | 190 | 200 | 210 | Ω |
| Vehicle charge permission | Load current (leakage current) between a-b when switch k OFF | | | 2 | mA |
| | Vce(collector-emitter voltage of transistor "k") at collector current=10 mA | | | 0.5 | V |

Meanwhile, according to the embodiment of the present invention, the detector 130 detects a protective earth (PE) open between the EV 10 and the EVSE 20. Here, the PE refers to the grounding wire between the EVCC 100 and the EVSE 20, and the PE open refers to a state in which the grounding wire between the EVCC 100 and the EVSE 20 is disconnected. In the present specification, the PE open may also be referred to as a broken PE.

In the charging interface between the EVSE 20 and the EVCC 100 exemplified in FIG. 5, when the grounding wire is disconnected, i.e., a PE open occurs, the connector proximity detection line, i.e., the PP line, is connected to an on-board control power line, and thus a closed circuit is formed between the PP line and the DCP line, i.e., a vehicle charge permission line. In this circumstance, since the PP line operates as a pseudo grounding wire, even when the original grounding wire is disconnected, the pseudo grounding wire is present and thus the optocoupler f and the optocoupler g are not turned off and the charging procedure continues. In order to prevent such a problem, a false-drive preventing circuit is applied so that an unintended current flow during the charging can be prevented.

Meanwhile, in the charging interface between the EVSE 20 and the EVCC 100 exemplified in FIG. 5, an output state change of the optocoupler f or the optocoupler g may be used in order to detect the PE open. However, not only are the optocouplers expensive components but also the output state change of the optocoupler f or the optocoupler g does not necessarily indicate the PE open, a faster and more accurate method for detecting the PE open is required.

In the embodiment of the present invention, the circuit of the charging interface between the EVSE and the EV is modified to implement an inexpensiveness, fast, and accurate PE open structure.

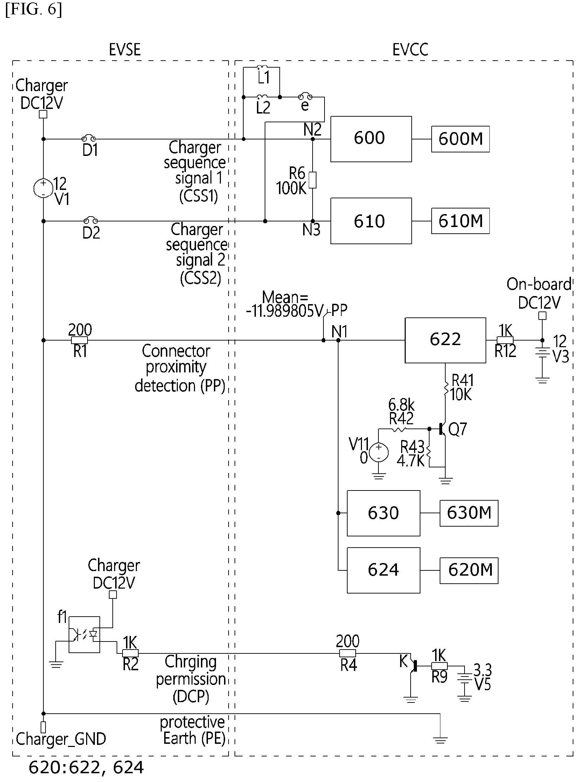

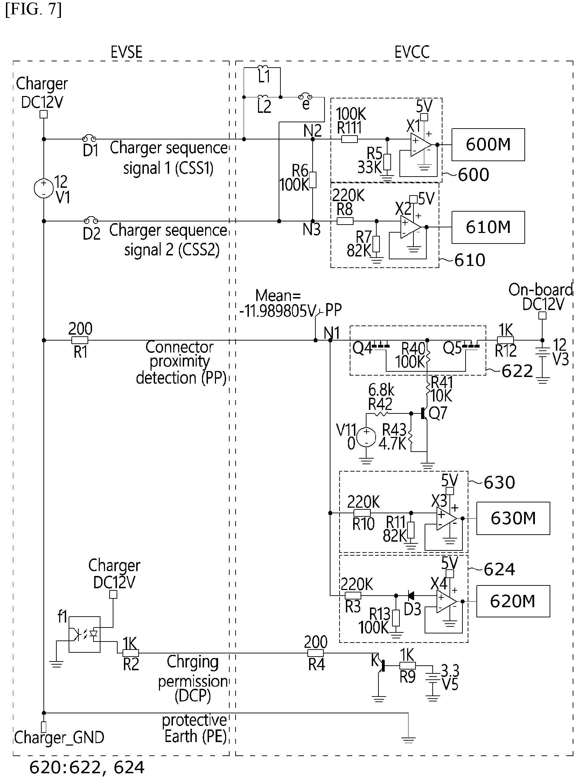

FIGS. 6 and 7 are equivalent circuit diagrams of the charging interface between the EVSE and the EVCC according to one embodiment of the present invention.

Referring to FIG. 6, the EVSE 20 and the EVCC 100 are connected through the charge sequence signal 1 CSS 1 line, the charge sequence signal 2 CSS 2 line, the connector proximity detection PP line, the vehicle charge permission DCP line, and the PE line, i.e., the ground winding line. That is, the connector 120 of the EVCC 100 may include the CSS1 line, the CSS2 line, the PP line, DCP line, and the PE line.

According to the embodiment of the present invention, the detector 130 of the EVCC 100 includes a CSS1 detector 600 connected to the CSS1 line to detect the first charge sequence signal received from the EVSE 20, a CSS2 detector 610 connected to the CSS2 line to detect the second charge sequence signal received from the EVSE 20, a negative voltage detector 620 connected to the PP line to detect a negative voltage of the PP line, and a proximity signal detector 630 connected to the PP line to detect a connector proximity signal of the EVSE 20.

In addition, the controller 120 of the EVCC 100 includes a CSS1 main control unit (MCU) 600M that generates a charge control signal using the detected value of the CSS1 detector 600, a CSS2 MCU 610M that generates a charge control signal using the detected value of the CSS2 detector 610, a PE open MCU 620M that generates a charge control signal for a PE open using the detected value of the negative voltage detector 620, and a PP MCU 630M that generates a charge control signal using the detected value of the proximity signal detector 630. Although the CSS1 MCU 600M, the CSS2 MCU 610M, the PE open MCU 620M, and the PP MCU 630M are shown as independent MCUs, the present invention is not limited thereto, and the CSS1 MCU 600M, the CSS2 MCU 610M, the PE open MCU 620M, and the PP MCU 630M may be implemented as a single integrated MCU.

The PE open MCU 620M is connected to the negative voltage detector 620, and when a voltage value detected by the negative voltage detector 620 is within a predetermined value, the PE open MCU 620M determines that the PE between the EVSE 20 and the EVCC 100 is open.

To describe more specifically, as shown in FIG. 5, in a normal state in which the PE is not open, a closed circuit is formed between the grounding wire and the DCP line, and thus a voltage value across the PP line becomes 0 V. However, in a state in which the PE is open, a negative voltage is applied to the PP line. Accordingly, in the embodiment of the present invention, the PE open is to be detected using the voltage value across the PP line.

According to the embodiment of the present invention, the negative voltage detector 620 includes a dual field effect transistor (FET) 622 and a negative voltage monitoring circuit 624, which are connected to the PP line. Here, the false-drive preventing circuit of FIG. 5 may be omitted due to the dual FET. The dual FET 622 may include two FETs Q4 and Q5 connected back-to-back. Accordingly, in the present specification, the dual FET 622 may be referred to as a back-to-back FET. The back-to-back FET is disposed between a first node N1 of the PP line and an on-board DC 12 V. In the back-to-back FET, the two FETs Q4 and Q5 are connected in series, but body diodes are connected in opposite directions to each other so that a bidirectional current flow is blocked. When the back-to-back FET is disposed between the first node N1 of the PP line and the on-board DC 12V, a current flow through the PP line is possible in a direction from the EVSE 20 toward the EVCC 100, but the current flow through the PP line is blocked in a direction from the EVCC 100 toward the EVSE 20. Accordingly, the formation of a closed circuit between the DCP line and the PP line can be prevented even when the PE is opened.

According to the embodiment of the present invention, the negative voltage monitoring circuit 624 is connected to the first node N1 of the PP line. The negative voltage monitoring circuit 624 may include a voltage divider resistor and an OP amp X4. Here, the voltage divider resistor is disposed between the first node N1 of the PP line and the OP amp X4 to divide a voltage applied to the OP amp X4. For example, the voltage divider resistor includes a first resistor R3 and a second resistor R13, one end of the first resistor R3 may be connected to the first node N1 of the PP line, and the other end of the first resistor R3 may be connected to one end of the second resistor R13 and the OP amp X4. In this case, the first resistor R3 may have a resistance of 100 kΩ or more, preferably, 100 kΩ or more and 1000 kΩ or less, and, more preferably, 100 kΩ or more and 500 kΩ or less. In this way, when the first resistor R3 of the voltage divider resistor is designed to be 100 kΩ or more, a structure capable of detecting an accurate voltage value without electrically affecting the surrounding circuits may be obtained.

According to the embodiment of the present invention, the negative voltage monitoring circuit 624 may further include a diode D3 disposed between the voltage divider resistor and the OP amp X4. A cathode of the diode D3 may be is connected to the voltage divider resistor, and an anode thereof may be connected to the OP amp X4. Accordingly, a current flow from the OP amp X4 toward the voltage divider resistor is blocked, and the negative voltage of the PP line may be monitored.

Meanwhile, the PE open MCU 620M is connected to the negative voltage detector 620, and when a voltage value detected by the negative voltage detector 620 is within a predetermined value, the PE open MCU 620M determines that the PE between the EVSE 20 and the EVCC 100 is open. To this end, the PE open MCU 620M may store a voltage matching table for estimating a negative voltage using a voltage value detected by the negative voltage detector 620 in advance. Table 3 is an example of the voltage matching table that the PE open MCU 620M stores in advance. For example, when a voltage value detected by the negative voltage detector 620 is 0.05 V, the PE open MCU 620M may estimate that a voltage value of the PP line is -1 V, when the voltage value detected by the negative voltage detector 620 is 0.92 V, the PE open MCU 620M may estimate that the voltage value of the PP line is -5 V, and when the voltage value detected by the negative voltage detector 620 is 1.83 V, the PE open MCU 620M may estimate that the voltage value of the PP line is -8.8 V. In addition, when the voltage value detected by the negative voltage detector 620 is 0.68 V to 3.08 V, the PE open MCU 620M may determine that a meaningful negative voltage is applied to the PP line and that the PE is in an open state.

**[Table 3]**

| Voltage value (V) of PP line | Detected voltage value (V) | PE open detection range |
|---|---|---|
| 0 | 0 | |
| -1 | 0.05 | |
| -2 | 0.24 | |
| -3 | 0.46 | |
| -4 | 0.68 | PE open detection |
| -5 | 0.92 | |
| -6 | 1.16 | |
| -7 | 1.4 | |
| -8 | 1.64 | |
| -8.8 | 1.83 | |
| -9 | 1.88 | |
| -10 | 2.12 | |
| -11 | 2.35 | |
| -12 | 2.6 | |
| -13 | 2.85 | |
| -14 | 3.08 | |
| -15 | 3.32 | |
| -16 | 3.51 | |

As in the embodiment of the present invention, when the PE open is detected using the negative voltage applied to the PP line, faster and more accurate PE open detection is possible compared to when the PE open is detected using the output state changes of the optocoupler f and the optocoupler g of FIG. 5.

As in the embodiment of the present invention, when the negative voltage detector 620 is disposed on the PP line, the optocoupler f and the optocoupler g of FIG. 5 may be replaced with inexpensive components. That is, according to the embodiment of the present invention, the CSS1 detector 600 detects the voltage value of the CSS1 line, and the CSS2 detector 610 detects the voltage value of the CSS2 line. To this end, the CSS1 detector 600 may include the voltage divider resistor and an OP amp X1, and the CSS2 detector 610 may include the voltage divider resistor and an OP amp X2.

The CSS1 MCU 600M may estimate a voltage value of the CSS1 line using the result value of the CSS1 detector 600 and detect the first charge sequence signal, and the CSS2 MCU 610M may estimate a voltage value of the CSS2 line using the result value of the CSS2 detector 610 and detect the second charge sequence signal. When the first charge sequence signal and the second charge sequence signal are detected, the controller 110 may perform subsequent processes for charging, that is, detecting a connector proximity detection signal from the EVSE 20 and transmitting a charge permission signal to the EVSE 20.

In this way, when the PE open is detected using the negative voltage detection of the PP line, the optocouplers in the CSS1 and CSS2 lines may be replaced with the OP amps so that production costs can be significantly reduced.

In this case, the CSS1 detector 600 may include the voltage divider resistor and the OP amp X1. Here, the voltage divider resistor may be disposed between a second node N2 of the CSS1 line and the OP amp X1 to divide a voltage applied to the OP amp X1. For example, the voltage divider resistor may include a first resistor R111 and a second resistor R5, one end of the first resistor R111 may be connected to the second node N2 of the CSS1 line, and the other end of the first resistor R111 may be connected to one end of the second resistor R5 and the OP amp X1. In this case, the first resistor R111 may have a resistance of 100 kΩ or more, preferably, 100 kΩ or more and 1000 kΩ or less, and, more preferably, 100 kΩ or more and 500 kΩ or less. Likewise, the CSS2 detector 610 may include a voltage divider resistor and the OP amp X2. Here, the voltage divider resistor may be disposed between a third node N3 of the CSS2 line and the OP amp X2 to divide a voltage applied to the OP amp X2. For example, the voltage divider resistor may include a first resistor R8 and a second resistor R7, one end of the first resistor R8 may be connected to the second node N2 of the CSS2 line, and the other end of the first resistor R8 may be connected to one end of the second resistor R7 and the OP amp X2. In this case, the first resistor R8 may have a resistance of 100 kΩ or more, preferably, 100 kΩ or more and 1000 kΩ or less, and, more preferably, 100 kΩ or more and 500 kΩ or less.

When each of the CSS1 detector 600 and the CSS2 detector 610 includes the voltage divider resistor and when the EVSE 20 outputs a waveform of 12 V, the CSS1 detector 600 and the CSS2 detector 610 may obtain result values that are lower than 12 V, for example, the result values of about 3 V, and the controller 120 may estimate the voltage values of the CSS1 line and the CSS2 line using the result values of the CSS1 detector 600 and the CSS2 detector 610. In particular, when the first resistor of the voltage divider resistor of each of the CSS1 detector 600 and the CSS2 detector 610 is designed to have a resistance of 100 kΩ or more, even when a voltage of 16 V is applied to the input line, each of the CSS1 detector 600 and the CSS2 detector 610 may obtain a result value that is lower than 16 V, for example, the result value of about 4 V. In this way, according to the embodiment of the present invention, when each of the CSS1 detector 600 and the CSS2 detector 610 includes the voltage divider resistor, the controller 120 may also detect a high voltage value of each of the CSS1 line and the CSS2 line, for example, a voltage value of 12 V or more and 16 V or less. In particular, according to the embodiment of the present invention, when the voltage divider resistor of each of the CSS1 detector 600 and the CSS2 detector 610 includes a high first resistor of 100 kΩ or more, electrical influence of the CSS1 detector 600 and the CSS2 detector 610 on the PP line can be minimized so that negative voltage detection accuracy of the PP line can be increased.

Meanwhile, according to the embodiment of the present invention, the proximity signal detector 630 may also include a voltage divider resistor and an OP amp X3. Here, the voltage divider resistor is disposed between the first node N1 of the PP line and the OP amp X3 to divide a voltage applied to the OP amp X3. For example, the voltage divider resistor includes a first resistor R10 and a second resistor R11, one end of the first resistor R11 may be connected to the first node N1 of the PP line, and the other end of the first resistor R10 may be connected to one end of the second resistor R11 and the OP amp X3. In this case, the first resistor R11 may have a resistance of 100 kΩ or more, preferably, 100 kΩ or more and 1000 kΩ or less, and, more preferably, 100 kΩ or more and 500 kΩ or less. According to the embodiment of the present invention, when the proximity signal detector 630 includes the voltage divider resistor, the controller 120 may also detect a high voltage value of 12 V or more and 16 V or less applied to the input line. In addition, when the voltage divider resistor of the proximity signal detector 630 includes the high first resistor R11 of 100 kΩ or more, electrical influence of the proximity signal detector 630 on the PP line can be minimized so that negative voltage detection accuracy of the PP line can be increased.

In this way, as shown in FIGS. 6 and 7, the dual FET 622, the negative voltage monitoring circuit 624, and the proximity signal detector 630 may be connected to the first node N1 of the PP line. Thus, in a normal state, a proximity detection signal may be transmitted in a direction from the EVSE 20 toward the EVCC 100 through the dual FET 622, and the proximity detection signal may be detected by the proximity signal detector 630. In addition, in a state in which the PE is open, the formation of a closed circuit between the DCP line and the PP line is prevented by the dual FET 622, and a negative voltage applied to the PP line may be detected by the negative voltage monitoring circuit 624.

Although the description has been made with reference to the preferred embodiments of the present invention, it should be understood that various alternations and modifications of the present invention can be devised by those skilled in the art to which the present invention pertains without departing from the spirit and scope of the present invention, which are defined by the appended claims.

### [Description of Reference Numerals]

10: electric vehicle
20: electric vehicle supply equipment
22: charging cable
100: electric vehicle charging controller
110: controller
120: connector
130: detector

## Claims

1. An electric vehicle charging controller (EVCC) comprising:
a charge sequence signal 1 (CSS1) detector configured to detect a first charge sequence signal received from electric vehicle supply equipment (EVSE) through a CSS1 line;
a charge sequence signal 2 (CSS2) detector configured to detect a second charge sequence signal received from the EVSE through a CSS2 line;
a negative voltage detector configured to detect a negative voltage of a connector proximity detection line; and
a controller configured to determine that a protective earth (PE) between the EVSE and the EVCC is opened when a voltage value detected by the negative voltage detector is within a predetermined value.

2. The EVCC of claim 1, wherein the controller estimates a negative voltage of the voltage value detected by the negative voltage detector using a pre-stored voltage matching table.

3. The EVCC of claim 1, wherein:
the negative voltage detector includes a back-to-back field effect transistor (FET) and a negative voltage monitoring circuit that are connected to the connector proximity detection line; and
the negative voltage monitoring circuit includes a voltage divider resistor and an operational amplifier (OP Amp).

4. The EVCC of claim 3, wherein the voltage divider resistor includes a first resistor and a second resistor,
one end of the first resistor is connected to the connector proximity detection line, and
the other end of the first resistor is connected to one end of the second resistor and the OP Amp.

5. The EVCC of claim 4, wherein the first resistor has a resistance of 100 kΩ or more.

6. The EVCC of claim 1, further comprising a proximity signal detector connected to the connector proximity detection line and configured to detect a connector proximity signal of the EVSE,
wherein the proximity signal detector includes a voltage divider resistor and an operational amplifier (OP Amp).

7. The EVCC of claim 1, wherein:
the CSS1 detector includes a voltage divider resistor and an operational amplifier (OP Amp); and
the controller determines whether the first charge sequence signal is received according to a voltage value detected by the CCS1 detector.

8. The EVCC of claim 7, wherein the voltage divider resistor includes a first resistor and a second resistor,
one end of the first resistor is connected to the CSS1 line,
the other end of the first resistor is connected to one end of the second resistor and the OP Amp, and
the first resistor has 100 kΩ or more.

9. The EVCC of claim 1, wherein:
the CCS2 detector includes a voltage divider resistor and an operational amplifier (OP Amp); and
the controller determines whether the second charge sequence signal is received according to a voltage value detected by the CCS2 detector.

10. The EVCC of claim 8, wherein the voltage divider resistor includes a first resistor and a second resistor,
one end of the first resistor is connected to the CSS2 line,
the other end of the first resistor is connected to one end of the second resistor and the OP Amp, and
the first resistor has a resistance of 100 kΩ or more.
